# EUROPEAN PATENT APPLICATION

(11) **EP 4 745 712 A1**
(43) Date of publication of application: **20.05.2026**
(21) Application number: 24845925.7
(22) Date of filing: 18.07.2024
(51) Int. Cl.: G06F 1/16

(54) **ELECTRONIC DEVICE**

(30) Priority: 21.07.2023 KR 20230095558; 07.11.2023 KR 20230152375
(71) Applicant: Samsung Electronics Co., Ltd., Suwon-si, Gyeonggi-do 16677 (KR)
(72) Inventor: WOO, Jeong, Suwon-si, Gyeonggi-do 16677 (KR)
(74) Representative: Gulde & Partner
(86) International application number: PCT/KR2024/010364
(87) International publication number: WO 2025/023623

(57) **Abstract**

The present invention relates to an electronic device. The electronic device according to an embodiment of the present invention may comprise: a first housing; a second housing rotatably coupled to the first housing; a hinge that includes a first hinge arm connected to the first housing and a second hinge arm connected to the second housing; a flexible display that is seated in the first housing and the second housing and spaced apart from each of the first hinge arm and the second hinge arm; a first plate that is disposed between the first hinge arm and the flexible display; and a second plate that is disposed between the second hinge arm and the flexible display and spaced apart from the first plate. The first plate may include a first edge portion having a first inclined surface that is inclined relative to the direction in which the first hinge arm and the flexible display are spaced apart.

## Description

### [Technical Field]

Various embodiments of the disclosure relate to an electronic device, e.g., an electronic device including a plate.

### [Background Art]

Advancing information communication and semiconductor technologies accelerate the spread and use of various electronic devices. In particular, recent electronic devices are being developed to carry out communication while carried on.

The term "electronic device" may mean a device performing a particular function according to its equipped program, such as a home appliance, an electronic scheduler, a portable multimedia player, a mobile communication terminal, a tablet PC, a video/sound device, a desktop PC or laptop computer, a navigation for automobile, etc. For example, the electronic devices may output stored information as voices or images. As electronic devices are highly integrated, and high-speed, high-volume wireless communication becomes commonplace, an electronic device, such as a mobile communication terminal, is recently being equipped with various functions. For example, an electronic device comes with the integrated functionality, including an entertainment function, such as playing video games, a multimedia function, such as replaying music/videos, a communication and security function, such as for mobile banking, and a scheduling or e-wallet function. These electronic devices have been downsized to be conveniently carried by users.

### [Disclosure of Invention]

### [Solution to Problems]

An electronic device according to an embodiment of the disclosure may comprise a first housing, a second housing rotatably disposed with respect to the first housing, a hinge including a first hinge arm connected to the first housing and a second hinge arm connected to the second housing, a flexible display disposed on the first housing and the second housing and spaced apart from each of the first hinge arm and the second hinge arm, a first plate disposed between the first hinge arm and the flexible display, and a second plate disposed between the second hinge arm and the flexible display and spaced apart from the first plate. The first plate may comprise a first edge portion including a first inclined surface inclined with respect to a direction in which the first hinge arm and the flexible display are spaced apart from each other.

An electronic device according to an embodiment of the disclosure may comprise a first housing, a second housing rotatably coupled to the first housing, a flexible display seated on the first housing and the second housing and formed to be at least partially deformable, a hinge rotatably connecting the first housing and the second housing, a first plate disposed between the flexible display and the hinge, and a second plate disposed between the flexible display and the hinge and spaced apart from the first plate. A folding space where the flexible display is deformed may be formed between the first plate and the second plate, and the first plate and the second plate may include edge portions inclined toward the folding space.

### [Brief Description of Drawings]

FIG. 1 is a block diagram illustrating an electronic device in a network environment according to an embodiment;
FIG. 2 is a view illustrating an unfolded state of an electronic device according to an embodiment of the disclosure;
FIG. 3 is a view illustrating a folded state of an electronic device according to an embodiment of the disclosure;
FIG. 4 is an exploded perspective view illustrating an electronic device according to an embodiment of the disclosure;
FIG. 5 is an exploded view illustrating a portion of an electronic device according to an embodiment of the disclosure;
FIG. 6A illustrates a portion of an electronic device according to an embodiment of the disclosure;
FIG. 6B illustrates a portion of an electronic device according to an embodiment of the disclosure;
FIG. 6C illustrates a portion of an electronic device according to an embodiment of the disclosure;
FIG. 6D illustrates a portion of an electronic device according to an embodiment of the disclosure;
FIG. 7A is a cross-sectional view illustrating a portion of an electronic device according to an embodiment of the disclosure;
FIG. 7B is a cross-sectional view illustrating a portion of an electronic device according to an embodiment of the disclosure;
FIG. 8 is a cross-sectional view illustrating a portion of an electronic device according to an embodiment of the disclosure;
FIG. 9 is a cross-sectional view illustrating a portion of an electronic device according to an embodiment of the disclosure;
FIG. 10 is a cross-sectional view illustrating a portion of an electronic device according to an embodiment of the disclosure;
FIG. 11 illustrates a portion of an electronic device according to an embodiment of the disclosure; and
FIG. 12 is a cross-sectional view illustrating a portion of an electronic device according to an embodiment of the disclosure.

### [Mode for the Invention]

The following description taken in conjunction with the accompanying drawings may provide an understanding of various exemplary implementations of the disclosure, including claims and their equivalents. The specific embodiments disclosed in the following description entail various specific details to aid understanding, but are regarded as one of various embodiments. Accordingly, it will be understood by those skilled in the art that various changes and modifications may be made to the various implementations described in the disclosure without departing from the scope and spirit of the disclosure. Further, descriptions of well-known functions and configurations may be omitted for clarity and brevity.

The terms and words used in the following description and claims are not limited to the bibliographical meaning, but may be used to clearly and consistently describe an embodiment of the disclosure. Therefore, it will be apparent to those skilled in the art that the following description of various implementations of the disclosure is provided only for the purpose of description, not for the purpose of limiting the disclosure defined as the scope of the claims and equivalent thereto.

The singular forms "a," "an," and "the" are intended to include the plural forms as well, unless the context clearly indicates otherwise. Thus, as an example, "a component surface" may be interpreted as including one or more of the surfaces of a component.

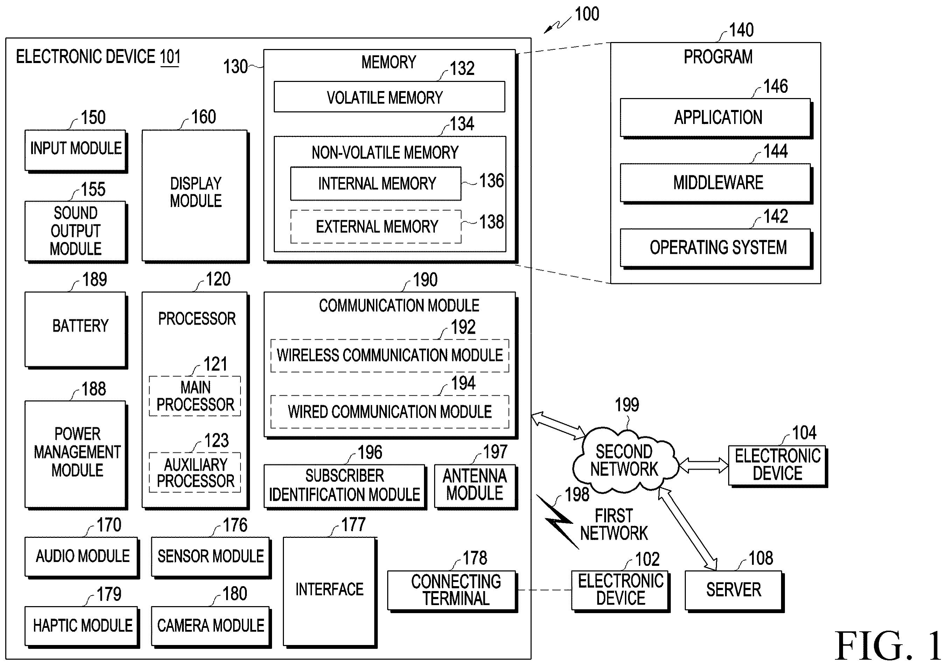

FIG. 1 is a block diagram illustrating an electronic device 101 in a network environment 100 according to various embodiments.

Referring to FIG. 1, the electronic device 101 in the network environment 100 may communicate with at least one of an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal According to an embodiment, the display module 160 may include a first display module 351 corresponding to the user's left eye and/or a second display module 353 corresponding to the user's right eye., a haptic module 179, a camera module 180, a power management module 188, a battery 189, a communication module 190, a subscriber identification module (SIM) 196, or an antenna module 197. In an embodiment, at least one (e.g., the connecting terminal 178) of the components may be omitted from the electronic device 101, or one or more other components may be added in the electronic device 101. According to an embodiment, some (e.g., the sensor module 176, the camera module 180, or the antenna module 197) of the components may be integrated into a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be configured to use lower power than the main processor 121 or to be specified for a designated function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. The artificial intelligence model may be generated via machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by other component (e.g., the processor 120) of the electronic device 101, from the outside (e.g., a user) of the electronic device 101. The input module 150 may include, for example, a microphone, a mouse, a keyboard, keys (e.g., buttons), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display 160 may include, for example, a display, a hologram device, or a projector and control circuitry to control a corresponding one of the display, hologram device, and projector. According to an embodiment, the display 160 may include a touch sensor configured to detect a touch, or a pressure sensor configured to measure the intensity of a force generated by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an accelerometer, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or motion) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device 104 via a first network 198 (e.g., a short-range communication network, such as Bluetooth^{™}, wireless-fidelity (Wi-Fi) direct, or infrared data association (IrDA)) or a second network 199 (e.g., a long-range communication network, such as a legacy cellular network, a 5G network, a next-generation communication network, the Internet, or a computer network (e.g., local area network (LAN) or wide area network (WAN)). These various types of communication modules may be implemented as a single component (e.g., a single chip), or may be implemented as multi components (e.g., multi chips) separate from each other. The wireless communication module 192 may identify or authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device). According to an embodiment, the antenna module 197 may include one antenna including a radiator formed of a conductor or conductive pattern formed on a substrate (e.g., a printed circuit board (PCB)). According to an embodiment, the antenna module 197 may include a plurality of antennas (e.g., an antenna array). In this case, at least one antenna appropriate for a communication scheme used in a communication network, such as the first network 198 or the second network 199, may be selected from the plurality of antennas by, e.g., the communication module 190. The signal or the power may then be transmitted or received between the communication module 190 and the external electronic device via the selected at least one antenna. According to an embodiment, other parts (e.g., radio frequency integrated circuit (RFIC)) than the radiator may be further formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, instructions or data may be transmitted or received between the electronic device 101 and the external electronic device 104 via the server 108 coupled with the second network 199. The external electronic devices 102 or 104 each may be a device of the same or a different type from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an Internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or health-care) based on 5G communication technology or IoT-related technology.

The electronic device according to various embodiments of the disclosure may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The storage medium readable by the machine may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program products may be traded as commodities between sellers and buyers. The computer program product may be distributed in the form of a machine-readable storage medium (e.g., compact disc read only memory (CD-ROM)), or be distributed (e.g., downloaded or uploaded) online via an application store (e.g., Play Store^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities. Some of the plurality of entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

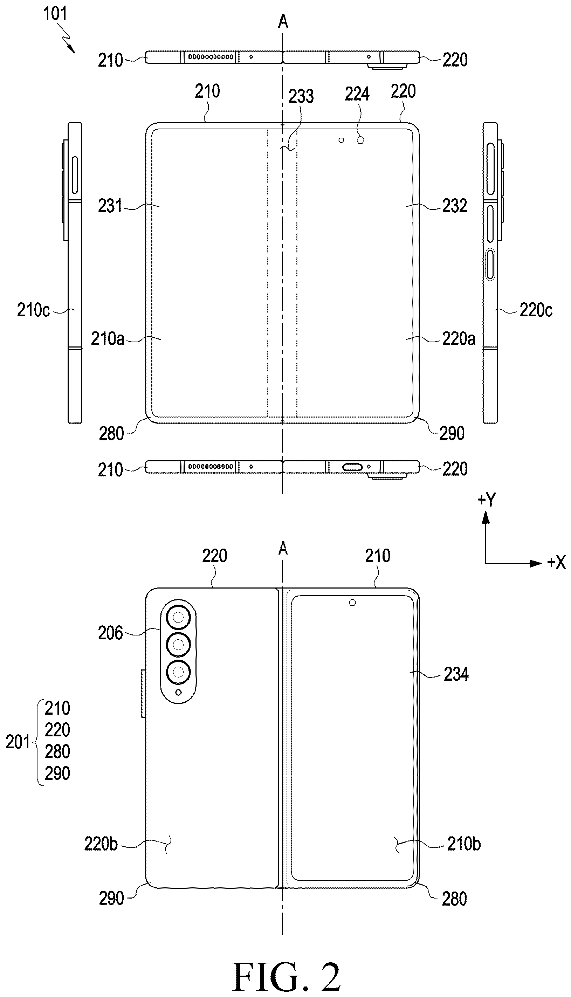

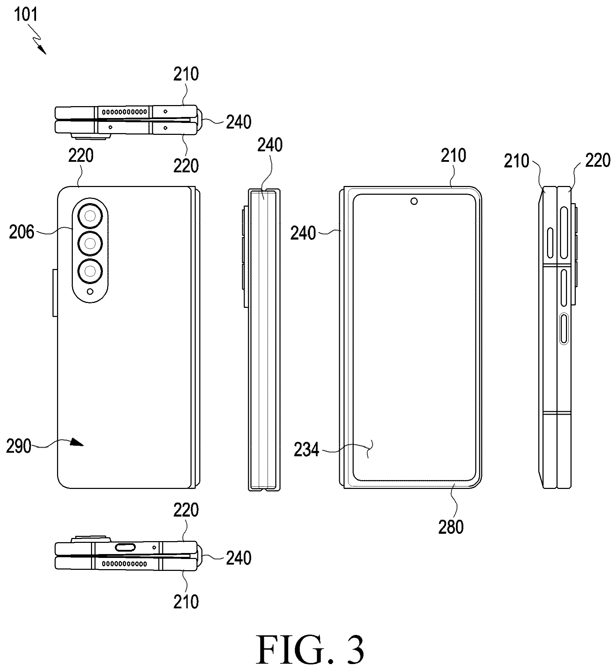

FIG. 2 is a view illustrating an unfolded state of an electronic device according to an embodiment of the disclosure; FIG. 3 is a view illustrating a folded state of an electronic device according to an embodiment of the disclosure;

Referring to FIGS. 2 and 3, an electronic device 101 may include a housing 201, a hinge cover 240 covering a foldable portion of the housing 201, and a display 230 disposed in a space formed by the housing 201. According to an embodiment, the surface where the screen output from the display 230 is exposed is defined as a front surface (e.g., the first front surface 210a and the second front surface 220a) of the electronic device 101. A surface opposite to the front surface is defined as a rear surface (e.g., the first rear surface 210b and the second rear surface 220b) of the electronic device 101. Further, a surface surrounding the space between the front surface and the rear surface is defined as a side surface (e.g., the first side surface 210c and the second side surface 220c) of the electronic device 101. The side surface of the electronic device 101 may be a side surface of at least one of the first housing 210 or the second housing 220. The electronic device 101 of FIGS. 2 and 3 may be referred to as a foldable electronic device, a portable electronic device, or a portable foldable electronic device. According to an embodiment, the housing 201 may be referred to as a foldable housing. The display 230 may be referred to as a "flexible display."

According to an embodiment, the housing 201 may include a first housing 210, a second housing 220 rotatable with respect to the first housing 210, a first rear cover 280, and a second rear cover 290. The housing 201 of the electronic device 101 are not limited to the shape and coupling shown in FIGS. 2 and 3 but may rather be implemented in other shapes or via a combination and/or coupling of other components. For example, in an embodiment, the first housing 210 and the first rear cover 280 may be integrally formed with each other, and the second housing 220 and the second rear cover 290 may be integrally formed with each other.

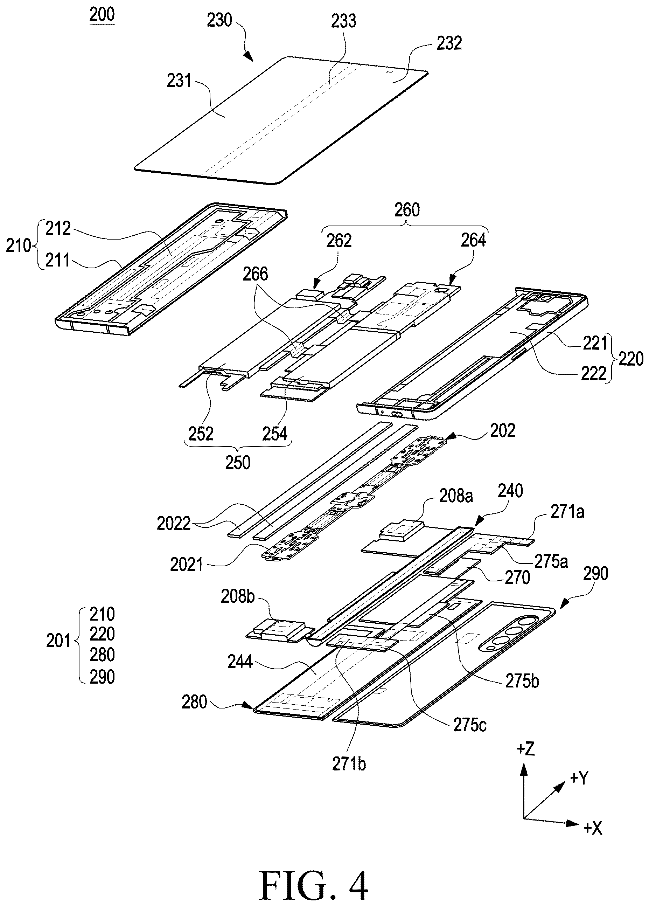

According to an embodiment, the first housing 210 may be connected to a hinge structure (e.g., the hinge assembly 202 of FIG. 4) and may include a first front surface 210a facing in a first direction and a first rear surface 210b facing in a second direction opposite to the first direction. The second housing 220 may be connected to the hinge assembly 202 and may include a second front surface 220a facing in a third direction and a second rear surface 220b facing in a fourth direction opposite to the third direction, and may rotate from the first housing 210 about the hinge assembly 202. Thus, the electronic device 101 may turn into a folded state or unfolded state. In the folded state of the electronic device 101, the first front surface 210a may face the second front surface 220a and, in the unfolded state, the third direction may be identical to the first direction. Hereinafter, unless otherwise mentioned, directions are described based on the unfolded state of the electronic device 101.

According to an embodiment, the first housing 210 and the second housing 220 are disposed on both sides of the folding axis A and be overall symmetrical in shape with respect to the folding axis A. As set forth below, the first housing 210 and the second housing 220 may have different angles or distances formed therebetween depending on whether the electronic device 101 is in the unfolded, folded, or intermediate state. According to an embodiment, the second housing 220 further includes the sensor area 224 where sensors (e.g., front camera) are disposed but, in the remaining area, the second housing 220 may be symmetrical in shape with the first housing 210.

According to an embodiment, there may be provided a plurality of (e.g., two) folding axes A parallel to each other. In the disclosure, the folding axis A is provided along the length direction (Y-axis direction) of the electronic device 101, but the direction of the folding axis A is not limited thereto. For example (not shown), the electronic device 101 may include the folding axis A extending along the width direction (e.g., X-axis direction).

According to an embodiment, the electronic device 101 may include a structure to which a digital pen may be attached. For example, the electronic device 101 may include a magnetic substance configured to attach the digital pen to a side surface of the first housing 210 or a side surface of the second housing 220. According to an embodiment, the electronic device 101 may include a structure into which a digital pen may be inserted. For example, a hole (not shown) into which the digital pen may be inserted may be formed in a side surface of the first housing 210 or a side surface of the second housing 220 of the electronic device 101.

According to an embodiment, the first housing 210 and the second housing 220 may at least partially be formed of a metal or non-metallic material with a rigidity selected to support the display 230. At least a portion formed of metal may provide a ground plane of the electronic device 101 and may be electrically connected with a ground line formed on a printed circuit board (e.g., the circuit board 260 of FIG. 4).

According to an embodiments, the sensor area 224 may be formed adjacent to an edge or corner of the second housing 220 and to have a predetermined area. However, the placement, shape, or size of the sensor area 224 is not limited to those illustrated. According to an embodiment, the sensor area 224 may be provided in a different corner of the second housing 220 or in any area between the top corner and the bottom corner or in the first housing 210. In an embodiment, components for performing various functions, embedded in the electronic device 101, may be exposed through the sensor area 224 or one or more openings in the sensor area 224 to the front surface of the electronic device 101. In various embodiments, the components may include various kinds of sensors. The sensor may include, e.g., at least one of a front camera, a receiver, or a proximity sensor.

According to an embodiment, the first rear cover 280 may be disposed on one side of the folding axis A on the rear surface of the electronic device 101 and have, e.g., a substantially rectangular periphery which may be surrounded by the first housing 210. Similarly, the second rear cover 290 may be disposed on the opposite side of the folding axis A on the rear surface of the electronic device 101 and its periphery may be surrounded by the second housing 220.

According to an embodiment, the first rear cover 280 and the second rear cover 290 may be substantially symmetrical in shape with respect to the folding axis (axis A). However, the first rear cover 280 and the second rear cover 290 are not necessarily symmetrical in shape. According to an embodiment, the electronic device 101 may include the first rear cover 280 and the second rear cover 290 in various shapes.

According to an embodiment, the first rear cover 280, the second rear cover 290, the first housing 210, and the second housing 220 may form a space where various components (e.g., a printed circuit board or battery) of the electronic device 101 may be disposed. According to an embodiment, one or more components may be arranged or visually exposed on/through the rear surface of the electronic device 101. For example, at least a portion of a sub display (e.g., the sub display 234 of FIG. 4) may be visually exposed through at least a portion of the first rear cover 280. According to an embodiment, one or more components or sensors may be visually exposed through at least a portion of the first rear cover 290. According to various embodiments, the sensor may include a proximity sensor and/or a camera module 206 (e.g., rear camera).

According to an embodiment, a front camera exposed to the front surface of the electronic device 101 through one or more openings provided in the sensor area 224 or the camera module 206 exposed through at least a portion of the second rear cover 290 may include one or more lenses, an image sensor, and/or an image signal processor. In an embodiment, two or more lenses (an infrared (IR) camera, a wide-angle lens, and a telephoto lens) and image sensors may be disposed on one surface of the electronic device 101.

According to an embodiment, the hinge cover 240 may be disposed between the first housing 210 and the second housing 220 to hide the internal components (e.g., the hinge assembly 202 of FIG. 4). According to an embodiment, the hinge cover 240 may be hidden by a portion of the first housing 210 and second housing 220 or be exposed to the outside depending on the state (e.g., the unfolded state (e.g., flat state) or folded state) of the electronic device 101.

According to an embodiment, as shown in FIG. 2, in the unfolded state of the electronic device 101, the hinge cover 240 may be hidden, and thus not exposed, by the first housing 210 and the second housing 220. As another example, as shown in FIG. 3, in the folded state (e.g., a fully folded state) of the electronic device 101, the hinge cover 240 may be exposed to the outside between the first housing 210 and the second housing 220. As another example, in an intermediate state in which the first housing 210 and the second housing 220 are folded with a certain angle, the hinge cover 240 may be partially exposed to the outside between the first housing 210 and the second housing 220. However, in this case, the exposed area may be smaller than that in the completely folded state. In an embodiment, the hinge cover 240 may include a curved surface.

According to an embodiment, the display 230 may be disposed in a space formed by the housing 201. For example, the display 230 may be seated on a recess formed by the housing 201 and may occupy most of the front surface of the electronic device 101. Thus, the front surface of the electronic device 101 may include the display 230 and a partial area of the first housing 210 and a partial area of the second housing 220, which are adjacent to the display 230. The rear surface of the electronic device 101 may include a first rear cover 280, a partial area of the first housing 210 adjacent to the first rear cover 280, a second rear cover 290, and a partial area of the second housing 220 adjacent to the second rear cover 290.

According to an embodiment, the display 230 may include a plurality of displays spaced apart from each other. For example, the display 230 may include a first display area 231 disposed on the first housing 210 and a second display area 232 disposed on the second housing 220. According to an embodiment, the first display area 231 and the second display area 232 may rotate about the folding axis A.

According to an embodiment, the display 230 may mean a display at least a portion of which may be transformed into a flat or curved surface. For example, the display 230 may be a foldable or flexible display. According to an embodiment, the display 230 may include a folding area 233, a first display area 231 disposed on one side of the folding area 233 (e.g., the left side of the folding area 233 of FIG. 2), and a second display area 232 disposed on the opposite side of the folding area 233 (e.g., the right side of the folding area 203 of FIG. 2). However, the segmentation of the display 230 is merely an example, and the display 230 may be divided into a plurality of (e.g., four or more, or two) areas depending on the structure or function of the display 200. For example, in the embodiment illustrated in FIG. 2, the display 230 may be divided into the areas by the folding area 233 or folding axis (axis A) extending in parallel with the Y axis but, according to an embodiment, the display 230 may be divided into the areas with respect to another folding area (e.g., a folding area parallel with the X axis) or another folding axis (e.g., a folding axis parallel with the X axis). According to an embodiment, the display 230 may be coupled with or disposed adjacent to a touch detection circuit, a pressure sensor capable of measuring the strength (pressure) of touches, and/or a digitizer (not shown) for detecting a magnetic field-type stylus pen.

According to an embodiment, the first display area 231 and the second display area 232 may be overall symmetrical in shape with respect to the folding area 233. According to an embodiment (not shown), unlike the first display area 231, the second display area 232 may include a notch depending on the presence of the sensor area 224, but the rest may be symmetrical in shape with the first display area 231. For example, the first display area 231 and the second display area 232 may include symmetrical portions and asymmetrical portions.

Described below are the operation of the first housing 210 and the second housing 220 and each area of the display 230 depending on the state (e.g., the unfolded state (or flat state) and folded state) of the electronic device 101.

According to an embodiment, when the electronic device 101 is in the unfolded state (flat state) (e.g., FIG. 2), the first housing 210 and the second housing 220 may be disposed to face in the same direction while being angled substantially at 180 degrees therebetween. The surface of the first display area 231 and the surface of the second display area 232 of the display 230 may be angled at 180 degrees therebetween while facing in the same direction (e.g., forward of the front surface of the electronic device). The folding area 233 may form the same plane with the first display area 231 and the second display area 232.

According to an embodiment, when the electronic device 101 is in the folded state (e.g., FIG. 3), the first housing 210 and the second housing 220 may be disposed to face each other. The surface of the first display area 231 and the surface of the second display area 232 of the display 230 may be angled at a small angle (e.g., an angle between 0 degrees and 10 degrees) therefrom while facing each other. At least a portion of the folding area 233 may be formed as a curve having a predetermined curvature.

According to an embodiment, when the electronic device 101 is in the intermediate state (not shown), the first housing 210 and the second housing 220 may be disposed at a certain angle therebetween. The surface of the first display area 231 of the display 230 and the surface of the second display area 232 may form an angle which is larger than the angle in the folded state and smaller than the angle in the unfolded state. The folding area 233 may at least partially have a curved surface with a predetermined curvature and, in this case, the curvature may be smaller than that when it is in the folded state.

FIG. 4 is an exploded perspective view illustrating an electronic device according to an embodiment of the disclosure;
Referring to FIG. 4, an electronic device 101 may include a housing 201, a display 230, a hinge assembly 202, a battery 250, and a board unit 260. The housing 201 may include a first housing 210, a second housing 220, a first rear cover 280, and a second rear cover 290. The configuration of the first housing 210, the second housing 220, the hinge cover 240, the first rear cover 280, and the second rear cover 290 of FIG. 4 may be identical in whole or part to the configuration of the first housing 210, the second housing 220, the hinge cover 240, the first rear cover 280, and the second rear cover 290 of FIG. 2 and/or FIG. 3.

According to an embodiment, the first housing 210 and the second housing 220 may be assembled together to be coupled to two opposite sides of the hinge assembly 202. According to an embodiment, the first housing 210 may include a first supporting area 212 that may support the components (e.g., the first circuit board 262 and/or the first battery 252) of the electronic device 101 and a first sidewall 211 surrounding at least a portion of the first supporting area 212. The first sidewall 211 may include a first side surface (e.g., the first side surface 210c of FIG. 2) of the electronic device 101. According to an embodiment, the second housing 220 may include a second supporting area 222 that may support the components (e.g., the second circuit board 264 and/or the second battery 254) of the electronic device 101 and a second sidewall 221 surrounding at least a portion of the second supporting area 222. The second sidewall 221 may include a second side surface (e.g., the second side surface 220c of FIG. 2) of the electronic device 101.

According to an embodiment, the display 230 (e.g., first display) may include a first display area 231, a second display area 232, a folding area 233, and a sub display 234 (e.g., second display). The configuration of the first display area 231, the second display area 232, and the folding area 233 of FIG. 3 may be identical in whole or part to the configuration of the first display area 231, the second display area 232, and the folding area 233 of FIG. 1 and/or FIG. 2.

According to an embodiment, the sub display 234 may display screen in a different direction from the display areas 231 and 232. For example, the sub display 234 may output screen in a direction opposite to the first display area 231. According to an embodiment, the sub display 234 may be disposed on the first rear cover 280.

According to an embodiment, the battery 250 may include a first battery 252 disposed in the first housing 210 and a second battery 254 disposed in the second housing 220. According to an embodiment, the first battery 252 may be connected with the first circuit board 262, and the second battery 254 may be connected to the second circuit board 264. According to an embodiment, the battery 250 may supply power to at least one component of the electronic device 101. According to an embodiment, the battery 250 may include, for example, a primary cell which is not rechargeable, a secondary cell which is rechargeable, or a fuel cell.

According to an embodiment, the board unit 260 may include a first circuit board 262 disposed in the first housing 210 and a second circuit board 264 disposed in the second housing 220. According to an embodiment, the first circuit board 262 and the second circuit board 264 may be electrically connected by at least one flexible circuit board 266. According to an embodiment, at least a portion of the flexible circuit board 266 may be disposed across the hinge assembly 202. According to an embodiment, the first circuit board 262 and the second circuit board 264 may be disposed in a space formed by the first housing 210, the second housing 220, the first rear cover 280, and the second rear cover 290. Components for implementing various functions of the electronic device 101 may be disposed on the first circuit board 262 and the second circuit board 264.

According to an embodiment, the hinge assembly 202 may include a hinge 2021. The hinge 2021 may rotatably couple the first housing 210 and the second housing 220. A plurality of hinges 2021 may be disposed to be spaced apart from each other in the length direction of the hinge assembly 202. The hinge assembly 202 may include a supporting plate 2022. The supporting plate 2022 may support at least a portion of the display 230. A plurality of supporting plates 2022 may be disposed to be spaced apart from each other in the length direction of the hinge assembly 202.

According to an embodiment, the electronic device 101 may include speakers 208a and 208b. According to an embodiment, the speakers 208a and 208b may convert the electric signal into sound. According to an embodiment, the speakers 208 and 208b may be disposed in a space formed by the first housing 210, the second housing 220, the first rear cover 280, and the second rear cover 290. According to an embodiment, the speakers 208a and 208b may include an upper speaker 208a positioned in an upper portion (+Y direction) of the electronic device 101 and a lower speaker 208b positioned in a lower portion (-Y direction) of the electronic device 101. In the disclosure, the speakers 208a and 208b are illustrated as positioned in one housing (e.g., the first housing 210 of FIG. 40, but this is an optional structure. For example, the speakers 208a and 208b may be positioned in at least one of the first housing 210 or the second housing 220. The configuration of the speakers 208a and 208b of FIG. 4 may be identical in whole or part to the configuration of the sound output module 155 of FIG. 1.

According to an embodiment, the electronic device 101 may include a rear member 270 (or rear case). According to an embodiment, the rear member 270 may be disposed in the housing 201 (e.g., the second housing 220). According to an embodiment, the rear member 270 may receive at least one antenna 275.

According to an embodiment, the electronic device 101 may include an antenna 275. The antennas 275a and 275b may include, e.g., an ultra-wide band (UWB) antenna 275a, a near-field communication (NFC) antenna, a wireless charging antenna, and/or a magnetic secure transmission (MST) antenna 275b. The antenna 275 may perform short-range communication with, e.g., an external device or may wirelessly transmit or receive power necessary for charging.

According to an embodiment, an antenna structure may be formed by a portion of the housing 201 or a combination thereof. For example, the antenna 275 may include a communication antenna 275c at least a portion of which is exposed to the outside and which forms at least a portion of the exterior of the electronic device 101. The communication antenna 275c may be used for communication (e.g., Wi-Fi) with an external electronic device. The communication antenna 275c may be connected to the upper portion 271a or the lower portion 271b of the rear member 270.

In the following detailed description, a configuration in which a pair of housings (or referred to as a 'housing') are coupled to be rotatable by a hinge assembly (or referred to as a 'hinge structure') is described as an example. However, it should be noted that the electronic device according to various embodiments of the disclosure is not limited thereto. For example, according to various embodiments, the electronic device may include three or more housings. In the embodiment disclosed below, a "pair of housings" may mean two rotatably-coupled housings among three or more housings.

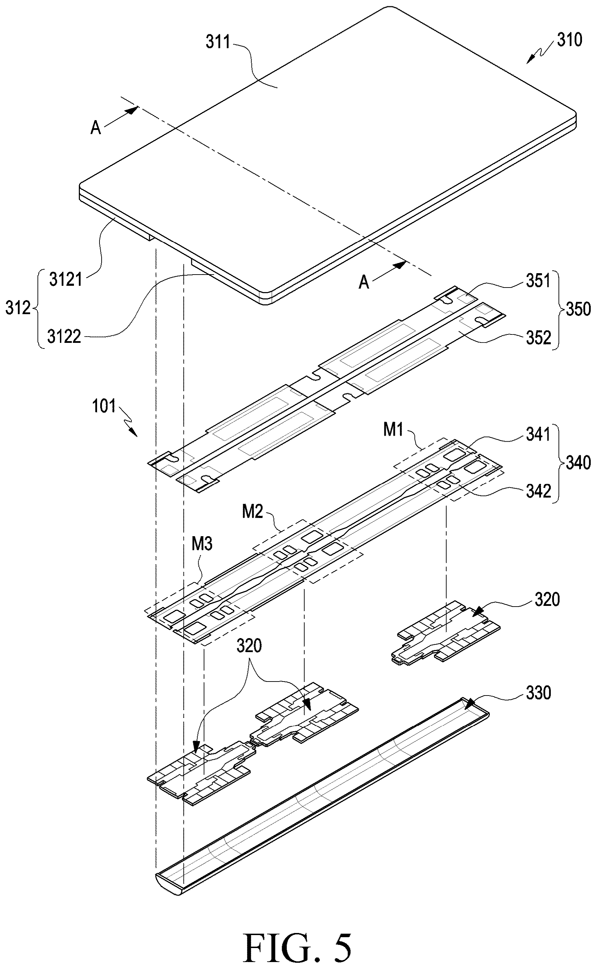

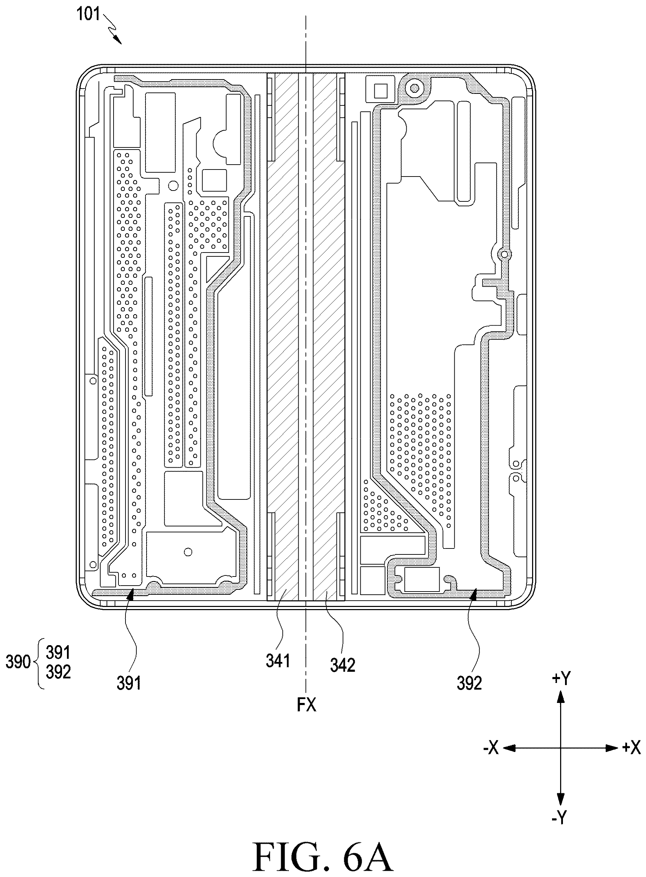

FIG. 5 is an exploded perspective view illustrating some components (e.g., the display 310, the hinge 320, the hinge cover 330, the plate 340, and the damping member 350) of an electronic device 101. Some or all of the components described with reference to FIG. 5 may be the same as those described with reference to FIGS. 1 to 4. Some or all of the components described with reference to FIG. 5 may be the same as those described with reference to FIGS. 6A to 12.

According to an embodiment, the electronic device 101 may include a display 310. The display 310 may be received in a housing (e.g., the housing 201 of FIGS. 2 to 4). The display 310 may display a screen outside the housing 201. The display 310 may be the same as the display 230 illustrated in FIGS. 2 to 4.

According to an embodiment, the display 310 may include a panel 311. The panel 311 may display a screen outside. The display 310 may include a digitizer 312. The digitizer 312 may be coupled to the panel 311. The digitizer 312 may detect a signal (e.g., a pressing signal of a pen) applied from the outside of the display 310.

According to an embodiment, the digitizer 312 may include a first digitizer 3121 and a second digitizer 3122. The first digitizer 3121 may be disposed at a position corresponding to the first housing (e.g., the first housing 210 of FIG. 4). The second digitizer 3122 may be disposed at a position corresponding to the second housing (e.g., the second housing 220 of FIG. 4). The first digitizer 3121 and the second digitizer 3122 may be spaced apart from each other.

According to an embodiment, the electronic device 101 may include a hinge 320. A plurality of hinges 320 may be disposed to be spaced apart from each other. The hinge 320 may be coupled to a housing (e.g., the housing 201 of FIGS. 2 to 4). The hinge 320 may rotatably connect the first housing (e.g., the first housing 210 of FIG. 4) and the second housing (e.g., the second housing 220 of FIG. 4). The first housing 210 and the second housing 220 may be rotated about the hinge 320. For example, the first housing 210 may be rotated about the hinge 320 with respect to the second housing 220. The hinge 320 may be a part of the hinge assembly 202 illustrated in FIG. 4. The hinge assembly 202 may include the hinge 320.

According to an embodiment, the electronic device 101 may include a hinge cover 330. At least a portion of the hinge cover 330 may be disposed between the first housing (e.g., the first housing 210 of FIG. 4) and the second housing (e.g., the second housing 220 of FIG. 4). At least a portion of the hinge 320 may be received in the hinge cover 330. The hinge cover 330 may be the same as the hinge cover 240 illustrated in FIGS. 2 to 4.

According to an embodiment, the electronic device 101 may include a plate 340. The plate 340 may be disposed between the display 310 and the hinge 320. The plate 340 may support the display 310. The plate 340 may be seated on the hinge 320. The plate 340 may be referred to as a "supporting plate". The plate 340 may be referred to as a "supporting member". The plate 340 may be referred to as a "supporting body". The plate 340 may be referred to as a "wing plate". The plate 340 may be referred to as a "body". The plate 340 may be referred to as a "guide member".

According to an embodiment, the plate 340 may include a first plate 341 and a second plate 342. The first plate 341 may be disposed at a position corresponding to the first housing (e.g., the first housing 210 of FIG. 4). The second plate 342 may be disposed at a position corresponding to the second housing (e.g., the second housing 220 of FIG. 4). The first plate 341 and the second plate 342 may be spaced apart from each other. The first plate 341 may be disposed between the panel 311 and the hinge 320. The second plate 342 may be disposed between the panel 311 and the hinge 320. The first plate 341 may be referred to as any one of "a first supporting plate, a first supporting member, a first supporting body, a first wing plate, a first body, or a first guide member". The second plate 342 may be referred to as any one of "a second supporting plate, a second supporting member, a second supporting body, a second wing plate, a second body, or a second guide member".

According to an embodiment, the electronic device 101 may include digitizers 3121 and 3122. The digitizers 3121 and 3122 may include a first digitizer 3121 and a second digitizer 3122. The first plate 341 may be disposed between the first digitizer 3121 and the hinge 320. The second plate 342 may be disposed between the second digitizer 3122 and the hinge 320.

According to an embodiment, the electronic device 101 may include a damping member 350. The damping member 350 may be disposed between the display 310 and the plate 340. The damping member 350 may be disposed between the digitizer 312 and the plate 340.

According to an embodiment, the damping member 350 may include a first damping member 351 disposed at a position corresponding to the first housing (e.g., the first housing 210 of FIG. 4). The damping member 350 may include a second damping member 352 disposed at a position corresponding to the second housing (e.g., the second housing 220 of FIG. 4). The first damping member 351 may be disposed between the panel 311 and the first plate 341. The second damping member 352 may be disposed between the panel 311 and the second plate 342. The first damping member 351 and the second damping member 352 may be spaced apart from each other.

According to an embodiment, the plate 340 may include portion M1, M2, and M3 corresponding to the hinge 320. The portion M1, M2, and M3 of the plate 340 and the hinge 320 may face each other in one direction (e.g., the +Z direction of FIG. 4).

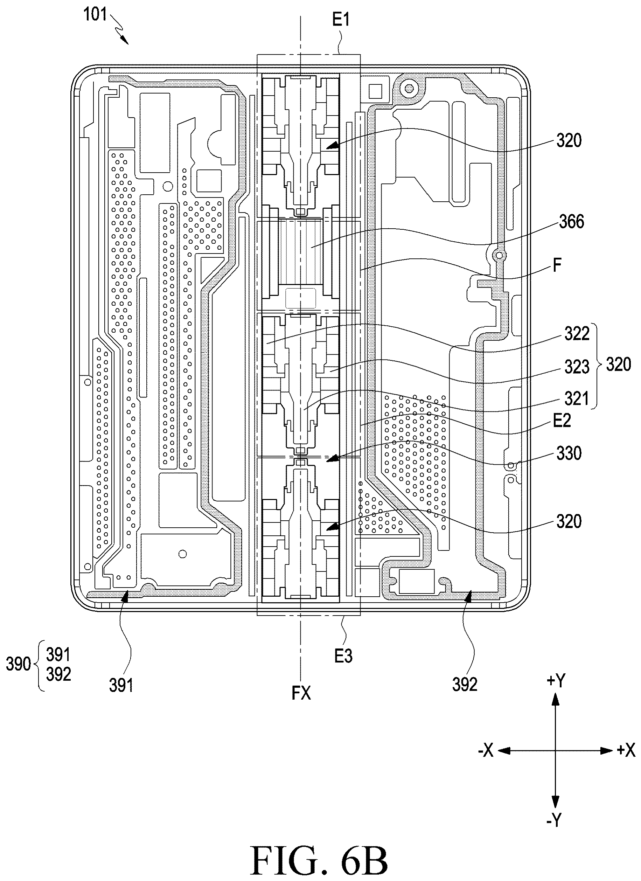

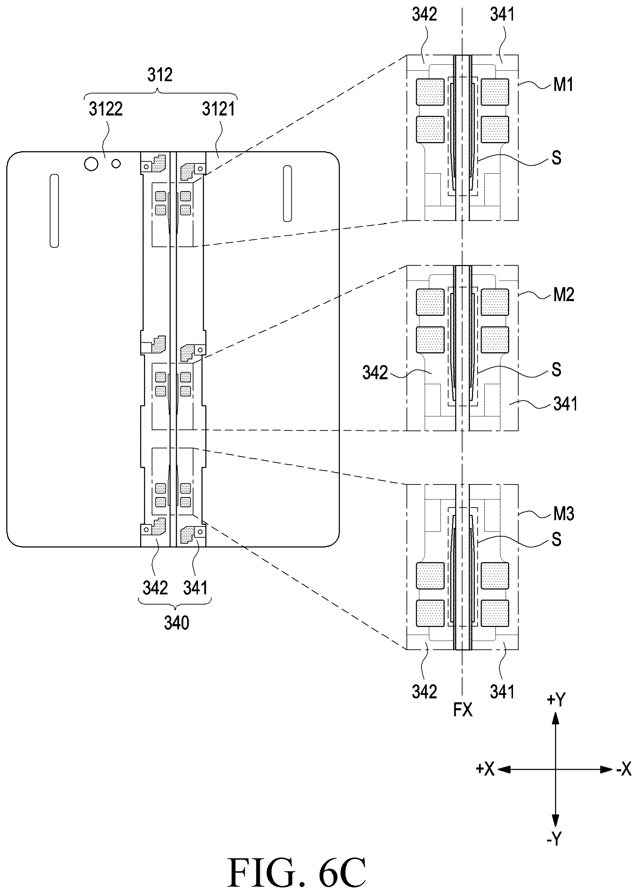

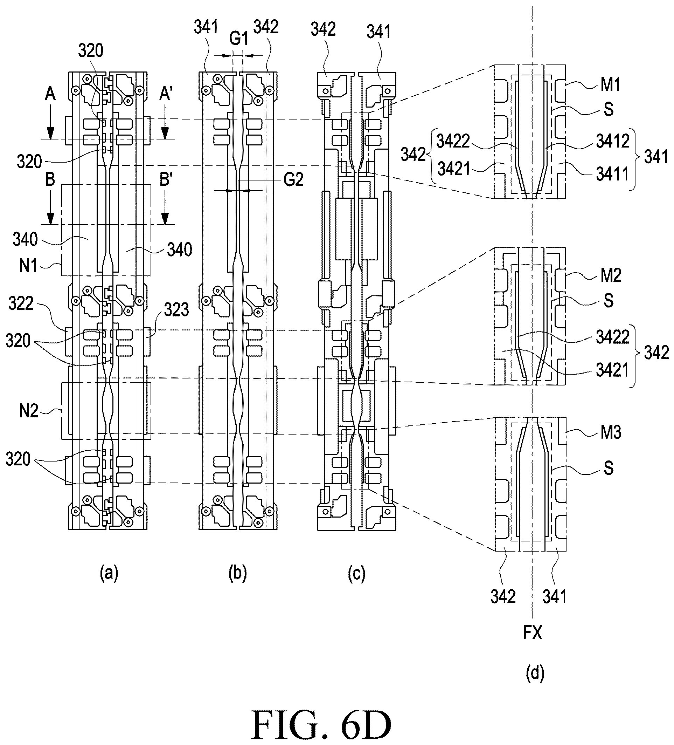

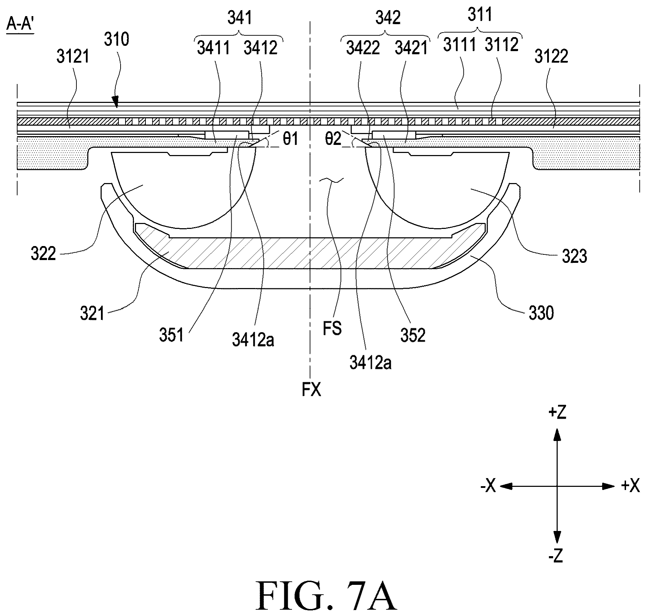

FIG. 6A is a view illustrating a state in which plates 341 and 342 are disposed in a housing 390 according to an embodiment of the disclosure. FIG. 6B is a view illustrating a state in which the plates 341 and 342 are removed in the state of FIG. 6A. FIG. 6C is a rear view of the digitizer 312 in a state in which the plates 341 and 342 are coupled. FIG. 6D is a view illustrating a relationship between the hinge 320 and the plate 330. FIG. 6A is a view illustrating an electronic device 101 in a state in which a display (e.g., the displays 231 and 232 of FIG. 2) is removed, viewed in one direction (e.g., the -Z direction of FIG. 4). (a) of FIG. 6D is a top view of the plate 340 in a state in which the hinge 320 is coupled. (b) of FIG. 6D is a top view of the plate 340. (c) of FIG. 6D is a rear view of the plate 340. (d) of FIG. 6D is an enlarged view of specific areas M1, M2, and M3 of (c) of FIG. 6D. Some or all of the components described with reference to FIGS. 6A to 6D may be the same as those described with reference to FIGS. 1 to 5. Some or all of the components described with reference to FIGS. 6A to 6D may be the same as those described with reference to FIGS. 7A to 12.

According to an embodiment, the electronic device 101 may include a housing 390. The housing 390 may be the same as the housing 201 illustrated in FIGS. 2 to 4. The display (e.g., the display 310 of FIG. 5) may be received in the housing 390.

According to an embodiment, the housing 390 may include a first housing 391 and a second housing 392. The first housing 391 and the second housing 392 may be rotatably coupled to each other. The hinge 320 may rotatably connect the first housing 391 and the second housing 392. At least a portion of the hinge 320 may be disposed between the first housing 391 and the second housing 392. At least a portion of the hinge cover 330 may be disposed between the first housing 391 and the second housing 392. The first housing 391 may be the same as the first housing 210 illustrated in FIG. 4. The second housing 392 may be the same as the second housing 220 illustrated in FIG. 4.

According to an embodiment, the electronic device 101 may include a flexible printed circuit board 366. The flexible circuit board 366 may be the same as the flexible circuit board 266 described with reference to FIGS. 1 to 4. The flexible circuit board 366 may connect a first circuit board (e.g., the first circuit board 262 of FIG. 4) disposed in the first housing 391 and a second circuit board (e.g., the second circuit board 264 of FIG. 4) disposed in the second housing 392. At least a portion of the flexible circuit board 366 may be disposed inside a hinge housing (e.g., the hinge housing 330 of FIG. 5). The flexible printed circuit board 366 may be disposed between a plurality of hinges 320.

According to an embodiment, the electronic device 101 may be divided into a first area E1, E2, and E3 in which the hinge 320 is disposed and a second area F in which the flexible printed circuit board 366 is disposed. The first area E1, E2, and E3 and the second area F may be arranged along a length direction (e.g., +Y direction) of the plate 340. The first area E1, E2, and E3 may overlap the first portion M1, M2, and M3 of the plate 340. The second area F may overlap the second portion N1 and N2 of the plate 340.

According to an embodiment, a first digitizer (e.g., the first digitizer 3121 of FIG. 5) may be disposed in the first housing 391. The second digitizer (e.g., the second digitizer 3122 of FIG. 5) may be disposed in the second housing 392. The first plate 341 may be disposed in the first housing 391. The second plate 342 may be disposed in the second housing 392. The first damping member (e.g., the first damping member 351 of FIG. 5) may be disposed in the first housing 391. The second damping member (e.g., the second damping member 352 of FIG. 5) may be disposed in the second housing 392.

According to an embodiment, a folding axis FX may be formed between the first housing 391 and the second housing 392. The first housing 391 may be rotated about the folding axis FX with respect to the second housing 392. The second housing 392 may be rotated about the folding axis FX with respect to the first housing 391. The folding axis FX may extend in the length direction (e.g., +Y or -Y direction) of the hinge cover 330. The folding axis FX may be formed in parallel with the rotation axis of the hinge 320. The folding axis FX may be formed between the first plate 341 and the second plate 342. The folding axis FX may be formed between a first digitizer (e.g., the first digitizer 3121 of FIG. 5) and a second digitizer (e.g., the second digitizer 3122 of FIG. 5). The folding axis FX may be formed between a first damping member (e.g., the first damping member 351 of FIG. 5) and a second damping member (e.g., the second damping member 352 of FIG. 5).

According to an embodiment, at least a portion of each of the hinge 320 and the hinge cover 330 may be disposed between the first housing 391 and the second housing 392. A plurality of hinges 320 may be disposed to be spaced apart from each other in the length direction (e.g., +Y or -Y direction) of the hinge cover 330. A plurality of hinges 320 may be spaced apart from each other along the folding axis FX. A plurality of hinges 320 may be arranged in an extending direction of the folding axis FX.

According to an embodiment, the hinge 320 may include a hinge body 321. The hinge body 321 may be disposed between the first housing 391 and the second housing 392. The hinge body 321 may be received in the hinge cover 330. The folding axis FX may extend through the hinge body 321.

According to an embodiment, the hinge 320 may include a first hinge arm 322. The first hinge arm 322 may be rotatably coupled to the hinge body 321. The first hinge arm 322 may be coupled to the first housing 391. The first hinge arm 322 may be rotated together with the first housing 391 about the folding axis FX. The first plate 341 may be seated on the first hinge arm 322. The first plate 341 may be disposed to correspond to the first hinge arm 322. The first hinge arm 322 may face the first plate 341 in one direction (e.g., the +Z direction).

According to an embodiment, the hinge 320 may include a second hinge arm 323. The second hinge arm 323 may be rotatably coupled to the hinge body 321. The second hinge arm 323 may be coupled to the second housing 392. The second hinge arm 323 may be rotated together with the second housing 392 about the folding axis FX. The second plate 342 may be seated on the second hinge arm 323. The second plate 342 may be disposed to correspond to the second hinge arm 323. The second hinge arm 323 may face the second plate 342 in one direction (e.g., the +Z direction).

According to an embodiment, the plate 340 may be disposed between the digitizer 312 and the hinge arms 322 and 323. The digitizer 312 may be seated on the plate 340 and may be coupled to the plate 340. The first plate 341 may be disposed between the first digitizer 3121 and the first hinge arm 322. The second plate 342 may be disposed between the second digitizer 3122 and the second hinge arm 323.

According to an embodiment, the first plate 341 and the second plate 342 may be spaced apart from each other. The folding axis FX may pass between the first plate 341 and the second plate 342.

According to an embodiment, the plate 340 may overlap the hinge 320 in one direction (e.g., the +Z direction). The plurality of hinges 320 may be spaced apart from each other in the length direction (e.g., +Y or -Y direction) of the plate 340. The first plate 341 may overlap the first hinge arm 322 in the first direction (e.g., the +Z direction), and the second plate 342 may overlap the second hinge arm 323 in the first direction (e.g., the +Z direction). The plate 340 may include an overlapping portion S overlapping the hinge 320. The overlapping portion S may be a portion of the plate 340 facing the hinge 320. A plurality of overlapping portions S may be formed to correspond to the plurality of hinges 320, respectively. For example, a plurality of hinges 320 may be disposed to be spaced apart from each other in the length direction (e.g., +Y or -Y direction) of the plate 340, and the overlapping portion S may be divided into a plurality of portion M1, M2, and M3 spaced apart from each other in the length direction (e.g., +Y or -Y direction) of the plate 340. Three hinges 320 may be disposed to be spaced apart from each other in the length direction of the plate 340, but the number of hinges 320 is not limited thereto.

According to an embodiment, the plate 340 may include first portions M1, M2, and M3 overlapping the hinge 320. The first portions M1, M2, and M3 may face the hinge 320 in one direction (e.g., -Z direction). The plate 340 may include second portions N1 and N2 that do not overlap the hinge 320. The second portions N1 and N2 may be positioned to be displaced from the hinge 320 in one direction (e.g., the -Z direction). The flexible circuit board 366 may be positioned to overlap the second portions N1 and N2 in one direction (e.g., the -Z direction).

According to an embodiment, in the first portions M1, M2, and M3, the first gap G1 between the first plate 341 and the second plate 342 may be larger than the second gap G2 between the first plate 341 and the second plate 342 in the second portion N1 and N2.

According to an embodiment, in the first portions M1, M2, and M3, an end portion of the first plate 341 may have an inclined shape (e.g., an inclined shape of the first edge portion 3412) as illustrated in FIG. 7A. In the first portions M1, M2, and M3, an end portion of the second plate 342 may have an inclined shape (e.g., an inclined shape of the second edge portion 3422) as illustrated in FIG. 7A.

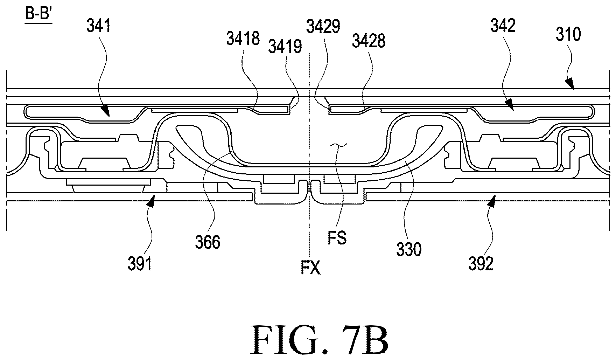

According to an embodiment, in the second portions N1 and N2, an end portion of the first plate 341 may not have an inclined shape as illustrated in FIG. 7B. For example, referring to FIG. 7B, the end portion 3419 of the first plate 341 may have a surface orthogonal to the direction in which the first plate 341 extends. In the second portions N1 and N2, an end portion of the second plate 342 may not have an inclined shape as illustrated in FIG. 7B. For example, referring to FIG. 7B, the end portion 3429 of the second plate 342 may have a surface orthogonal to the direction in which the second plate 342 extends.

According to an embodiment, the plate 340 may include body portions 3411 and 3421. The body portions 3411 and 3421 may be seated on the hinge 320. The body portions 3411 and 3421 may be portions of the plate 340. The first plate 341 may include a first body portion 3411. The first body portion 3411 may be seated on the first hinge arm 322. The second plate 342 may include a second body portion 3421. The second body portion 3421 may be seated on the second hinge arm 323.

According to an embodiment, the plate 340 may include edge portions 3412 and 3422. The edge portions 3412 and 3422 may extend from the body portions 3411 and 3421 toward the folding axis FX. The edge portions 3412 and 3422 may be integrated with the body portions 3411 and 3421. The first plate 341 may include a first edge portion 3412. The first edge portion 3412 may extend from the first body portion 3411 toward the folding axis FX. The first edge portion 3412 may extend from the first body portion 3411 toward the second plate 342. The second edge portion 3422 may extend from the second body portion 3421 toward the folding axis FX. The second edge portion 3422 may extend from the second body portion 3421 toward the first plate 341. The first edge portion 3412 and the second edge portion 3422 may be spaced apart from each other. The first edge portion 3412 and the second edge portion 3422 may face each other with the folding axis FX interposed therebetween.

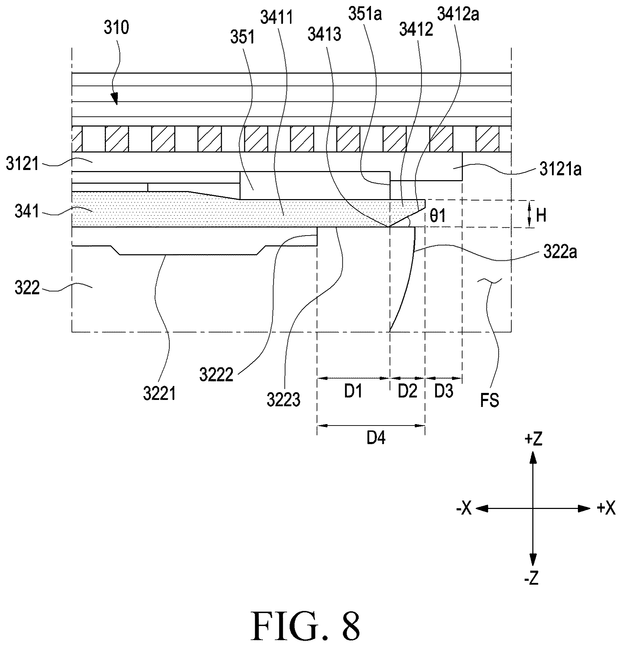

FIG. 7A is a cross-sectional view taken along reference line A-A' in a state in which components (e.g., the display 310, the hinge 320, the hinge cover 330, the plate 340, and the damping member 350) of FIG. 5 are assembled. FIG. 7B is a cross-sectional view taken along reference line B-B' of FIG. 6D in a state in which components (e.g., the display 310, the hinge 320, the hinge cover 330, the plate 340, and the damping member 350) of FIG. 5 are assembled. Some or all of the components described with reference to FIGS. 7A and 7B may be the same as those described with reference to FIGS. 1 to 6D. Some or all of the components described with reference to FIGS. 7A and 7B may be the same as those described with reference to FIGS. 8 to 12.

FIG. 7A may be a cross-sectional view taken along reference line A-A' in the first portions M1, M2, and M3 illustrated in FIG. 6D. FIG. 7B may be a cross-sectional view taken along reference line B-B' in the second portions N1 and N2 illustrated in FIG. 6D.

According to an embodiment, the hinge body 321 may be received in the hinge cover 330. The hinge body 321 may be fixed to the hinge cover 330. A portion of each of the first hinge arm 322 and the second hinge arm 323 may be surrounded by the hinge cover 330. The first hinge arm 322 and the second hinge arm 323 may be spaced apart from each other, and the folding axis FX may pass between the first hinge arm 322 and the second hinge arm 323.

According to an embodiment, the first plate 341 may be seated on the first hinge arm 322. The second plate 342 may be seated on the second hinge arm 323. The first plate 341 and the second plate 342 may be spaced apart from each other, and the folding axis FX may pass between the first plate 341 and the second plate 342.

According to an embodiment, the first damping member 351 may be disposed between the first digitizer 3121 and the first plate 341. The second damping member 352 may be disposed between the second digitizer 3122 and the second plate 342. The first damping member 351 and the second damping member 352 may be spaced apart from each other, and the folding axis FX may pass between the first damping member 351 and the second damping member 352.

According to an embodiment, the first digitizer 3121 may be disposed between the first damping member 351 and the panel 311. The second digitizer 3122 may be disposed between the second damping member 352 and the panel 311. The first digitizer 3121 and the second digitizer 3122 may be spaced apart from each other, and the folding axis FX may pass between the first digitizer 3121 and the second digitizer 3122.

According to an embodiment, the digitizer (e.g., the digitizer 312 of FIG. 5) may be integrally formed. For example, unlike in the embodiment of FIG. 5, in which the digitizer is divided into the first digitizer 3121 and the second digitizer 3122, the digitizer 312 may integrally correspond to the entire area of the panel 311 without a cut portion.

According to an embodiment, the panel 311 may include a first layer 3111 and a second layer 3112. The first layer 3111 and the second layer 3112 may be stacked on each other. The first layer 3111 may display a screen. The second layer 3112 may be disposed between the first layer 3111 and the plates 341 and 342. The second layer 3112 may be a metal layer including a lattice shape. The second layer 3112 may supplement the rigidity of the deformable first layer 3111. For example, the second layer 3112 may mitigate an impact applied to the first layer 3111. The second layer 3112 may support the first layer 3111. The second layer 3112 may be referred to as a "reinforcement layer". The second layer 3112 may be referred to as a "lattice layer".

According to an embodiment, the electronic device 101 may include a folding space FS. The folding space FS may be formed between the first hinge arm 322 and the second hinge arm 323. The folding space FS may be formed between the first plate 341 and the second plate 342. The folding space FS may be formed between the first damping member 351 and the second damping member 352. The folding space FS may be formed between the first digitizer 3121 and the second digitizer 3122. The first edge portion 3412 and the second edge portion 3422 may face each other with the folding space FS interposed therebetween. The folding axis FX may penetrate the folding space FS. The folding space FS may be a space formed between a first housing (e.g., the first housing 391 of FIG. 6A) and a second housing (e.g., the second housing 392 of FIG. 6A). The first housing 391 and the second housing 392 may be rotated about the folding axis FX, and the folding space FS may be used as a space required for rotation.

According to an embodiment, the electronic device 101 may include a panel 311, a plate 340, hinge arms 322 and 323, a hinge housing 330, and housings 391 and 392. The above-described components (e.g., the panel 311, the plate 340, the hinge arms 322 and 323, the hinge housing 330, and the housing 391 and 392) may be stacked in one direction (e.g., the -Z direction) in the order mentioned. The electronic device 101 may not include the digitizers 3121 and 3122 or the cushioning layers 351 and 352.

According to an embodiment, the first edge portion 3412 may extend from the first body portion 3411 toward the folding space FS. The first edge portion 3412 may be positioned between the first digitizer 3121 and the first hinge arm 322. The first edge portion 3412 may face the second edge portion 3422.

According to an embodiment, the second edge portion 3422 may extend from the second body portion 3421 toward the folding space FS. The second edge portion 3422 may be positioned between the second digitizer 3122 and the second hinge arm 323. The second edge portion 3422 may face the first edge portion 3421.

According to an embodiment, the second edge portion 3422 may extend obliquely from the second body portion 3421. The second edge portion 3422 may be inclined toward the folding space FS. The second edge portion 3422 may be inclined with respect to a direction (e.g., +Z direction) parallel to the folding axis FX. The second edge portion 3422 may be inclined with respect to a direction (e.g., the +X direction) in which the first plate 341 and the second plate 342 are spaced apart from each other. The second edge portion 3422 may have an inclination angle θ2 with respect to a direction (e.g., the +X direction) in which the first plate 341 and the second plate 342 are spaced apart from each other. The inclination angle θ2 may be formed between the second edge portion 3422 and the second hinge arm 323. The second edge portion 3422 may be inclined to be closer to the display 310 as it approaches the folding space FS. The second edge portion 3422 may include a second inclined surface 3422a at least partially facing the second hinge arm 323. The second edge portion 3422 may include a second inclined surface 3422a at least partially facing the hinge body 321.

Referring to FIG. 7B, end portions of the plates 341 and 342 may not be inclined in the second portion (e.g., the second portions N1 and N2 of FIG. 6D). The flexible printed circuit board 366 may be disposed in the second portions N1 and N2. The first plate 341 and the second plate 342 may cover at least a portion of the flexible circuit board 366. The first plate 341 may include a first plate portion 3418 and a first plate end portion 3419. The first plate end portion 3419 may protrude from the first plate portion 3418 toward the folding area FS. The first plate end portion 3419 may have a surface orthogonal to the direction in which the first plate 341 extends. The second plate 342 may include a second plate portion 3428 and a second plate end portion 3429. The second plate end portion 3429 may protrude from the second plate portion 3428 toward the folding area FS. The second plate end portion 3429 may have a surface orthogonal to the direction in which the second plate 342 extends. According to an embodiment of the disclosure, the first plate end portion 3419 and the second plate end portion 3429 may have a curved shape.

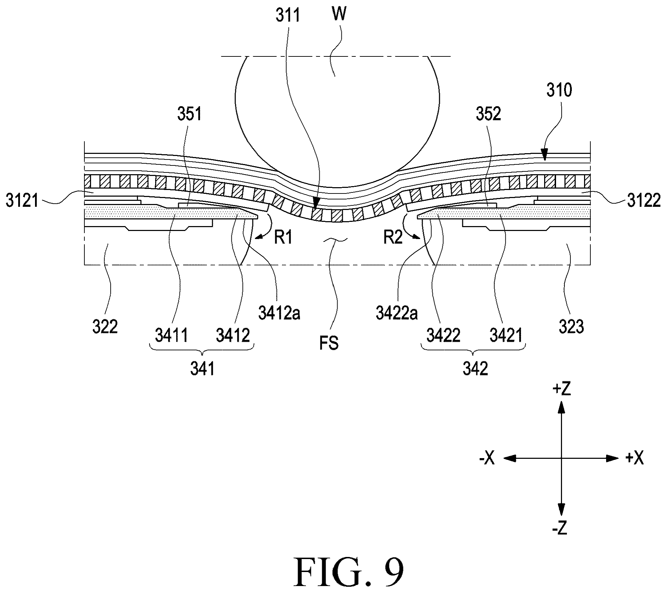

FIG. 8 is an enlarged view of a portion of FIG. 7A; Some or all of the components described with reference to FIG. 8 may be the same as those described with reference to FIGS. 1 to 7B. Some or all of the components described with reference to FIG. 8 may be the same as those described with reference to FIGS. 9 to 12.

According to an embodiment, the first edge portion 3412 may extend obliquely from the first body portion 3411. The first edge portion 3412 may be inclined toward the folding space FS. The first edge portion 3412 may be inclined with respect to a direction (e.g., +Z direction) parallel to the folding axis FX. The first edge portion 3412 may be inclined with respect to a direction (e.g., the +Z direction) in which the first hinge arm 322 and the flexible display 310 are spaced apart from each other. The first edge portion 3412 may be inclined with respect to a direction (e.g., the +X direction) in which the first plate 341 and the second plate 342 are spaced apart from each other. The first edge portion 3412 may have an inclination angle θ1 with respect to a direction (e.g., the +X direction) in which the first plate 341 and the second plate 342 are spaced apart from each other. According to an embodiment, the first edge portion 3412 may be formed so that the width of the first edge portion 3412 gradually decreases with respect to a direction (e.g., the +X direction) in which the first plate 341 and the second plate (e.g., the second plate 342 of FIG. 7A) are spaced apart from each other. An inclination angle θ1 may be formed between the first edge portion 3412 and the first hinge arm 322. The first edge portion 3412 may be inclined to be closer to the display 310 as it approaches the folding space FS. The first edge portion 3412 may include a first inclined surface 3412a at least partially facing the first hinge arm 322. The first edge portion 3412 may include a first inclined surface 3412a at least partially facing the hinge body 321.

According to an embodiment, the first plate 341 may be seated on the first hinge arm 322. The first hinge arm 322 may include a first portion 3221, a protrusion portion 3222, and a second portion 3223. The first portion 3221 may be spaced apart from the first plate 341. The protrusion portion 3222 may connect the first portion 3221 and the second portion 3223. The first plate 341 may be seated on the second portion 3223.

According to an embodiment, the first plate 341 may include a bending portion 3413. The bending portion 3413 may connect the first body portion 3411 and the first edge portion 3412. The bending portion 3413 may contact the second portion 3223. The first edge portion 3412 may extend obliquely from the bending portion 3413. The bending portion 3413 may be positioned between the protrusion portion 3222 and the hinge arm side surface 322a. The bending portion 3413 may be referred to as a "boundary portion", a "bent portion", or an "edge start portion". The bending portion 3413 may form a boundary between the first body portion 3411 and the first edge portion 3412. The bending portion 3413 may include a curved portion between the first body portion 3411 and the first edge portion 3412. The bending portion 3413, which is a portion of the first plate 341, may constitute at least a portion of the first body portion 3411 and the first edge portion 3412, which are integrally formed with each other. The first inclined surface 3412a may face the second portion 3223 of the first hinge arm 322.

According to an embodiment, the first hinge arm 322 may include a hinge arm side surface 322a facing the folding space FS. The first plate 341 may include a first inclined surface 3412a facing the folding space FS. The first damping member 351 may include a damping member surface 351a facing the folding space FS. The first digitizer 3121 may include a digitizer surface 3121a facing the folding space FS. The first inclined surface 3412a may be positioned to protrude further in one direction (e.g., the +X direction) than the damping member surface 351a. The digitizer surface 3121a may be positioned to protrude further in one direction (e.g., the +X direction) than the first inclined surface 3412a. The first digitizer 3121 may further protrude toward the folding space FS than the first plate 341. The first inclined surface 3412a and the hinge arm side surface 322a may be aligned along a direction (e.g., +Z direction) parallel to the folding axis FX.

According to an embodiment, the distance D4 from the protrusion portion 3222 to the hinge arm side surface 322a may range from 0.7 mm to 0.9 mm. The distance D4 from the protrusion portion 3222 to the hinge arm side surface 322a may be 0.8 mm. The distance D4 from the protrusion portion 3222 to the first inclined surface 3412a may range from 0.7 mm to 0.9 mm. The distance from the protrusion portion 3222 to the first inclined surface 3412a may be 0.8 mm. The distance D2 from the bending portion 3413 to the end portion of the first inclined surface 3412a may range from 0.1 mm to 0.2 mm. The distance D2 from the bending portion 3413 to an end portion of the first inclined surface 3412a may be 0.15 mm. The distance D1 from the protrusion portion 3222 to the bending portion 3413 may range from 0.6 mm to 0.7 mm. The distance D1 from the protrusion portion 3222 to the bending portion 3413 may be 0.65 mm. The distance D3 from the end portion of the first inclined surface 3412a to the digitizer surface 3121a may be smaller than the distance D4 from the protrusion portion 3222 to the end portion of the first inclined surface 3412a. The thickness H of the first edge portion 3412 in a direction parallel to the folding axis FX may range from 0.35 mm to 0.45 mm. The thickness H of the first edge portion 3412 in a direction parallel to the folding axis FX may be 0.4 mm. Numerical values (e.g., D1, D2, D3, D4, and H) of the above-described components are not limited thereto. For example, the numerical values (e.g., D1, D2, D3, D4, and H) of the above-described components are not limited to the above-described range, and may have numerical values outside the above-described range.

According to an embodiment, the description of the first plate 341 described above may be equally applied to the second plate 342 illustrated in FIG. 7A. For example, the second plate 342 may include a second body portion 3421, a second edge portion 3422, a bending portion, and a second inclined surface 3422a. For example, the description of the positional relationship (e.g., D1, D2, D3, D4, and H) between the second plate 342, the second hinge arm 323, the second damping member 352, and the second digitizer 3122 may be identically applied to the description of the positional relationship between the above-described components (e.g., the first plate 341, the first hinge arm 322, the first damping member 351, and the first digitizer 3121).

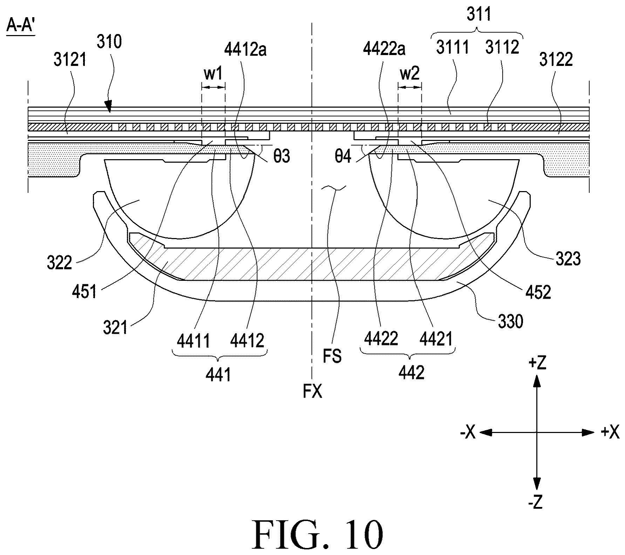

FIG. 9 is a view illustrating a portion of a cross-sectional view of the electronic device 101 when a load is applied to the display 310. Some or all of the components described with reference to FIG. 9 may be the same as those described with reference to FIGS. 1 to 8. Some or all of the components described with reference to FIG. 9 may be the same as those described with reference to FIGS. 10 to 12.

According to an embodiment, when the load body W is placed on the display 310, the display 310 may be bent downward (e.g., in the -Z direction). A portion of the display 310 may be bent toward the folding space FS. At least a portion of the panel 311 of the display 310 may be bent toward a space between the first plate 341 and the second plate 342. The plates 341 and 342 and the damping members 351 and 352 may support the display 310. When the load W is applied to the display 310, the first inclined surface 3412a may move toward the first hinge arm 322. When the load W is applied to the display 310, the first inclined surface 3412a may contact the first hinge arm 322. When the load W is applied to the display 310, the second inclined surface 3422a may move toward the second hinge arm 323. When the load W is applied to the display 310, the second inclined surface 3422a may contact the second hinge arm 323. The first edge portion 3412 may include a flexible material. The second edge portion 3422 may include a flexible material. When the load W is applied to the display 310, the first damping member 351 may be pressed in a direction in which the display 310 is deformed. When the load W is applied to the display 310, the second damping member 352 may be pressed in a direction in which the display 310 is deformed. When the load W is applied to the display 310, the thicknesses of the damping members 351 and 352 may be changed. The damping members 351 and 352 may include a flexible material. When the load W is applied to the display 310, the first edge portion 3412 may be deformed along the first direction R1. The first edge portion 3412 may include a deformable material, and may be deformed toward the hinge arm 322 when the load W is applied to the display 310. When the load W is applied to the display 310, the first inclined surface 3412a of the first edge portion 3412 may be deformed to be arranged in parallel with one surface of the first body portion 3411. When the load W is applied to the display 310, the second edge portion 3422 may be deformed along the second direction R2. The second edge portion 3422 may include a deformable material, and may be deformed toward the hinge arm 323 when the load W is applied to the display 310. When the load W is applied to the display 310, the second inclined surface 3422a of the second edge portion 3422 may be deformed to be arranged in parallel with one surface of the second body portion 3421. When the load W is applied to the display 310, the first hinge arm 322 may support the first plate 341 including the first inclined surface 3412a. When the load W is applied to the display 310, the second hinge arm 323 may support the second plate 342 including the second inclined surface 3422a.

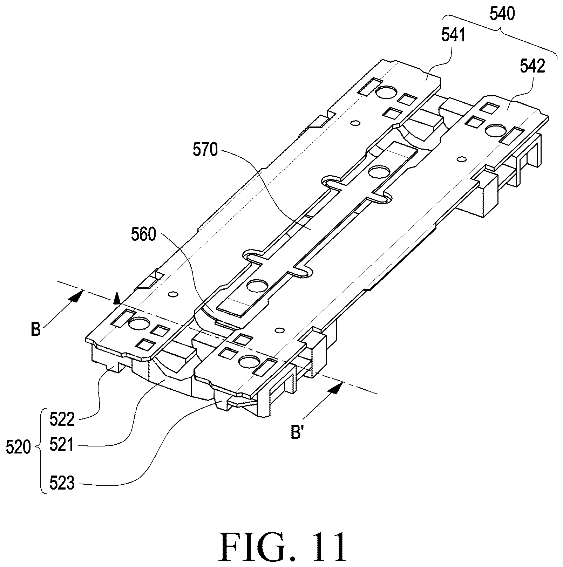

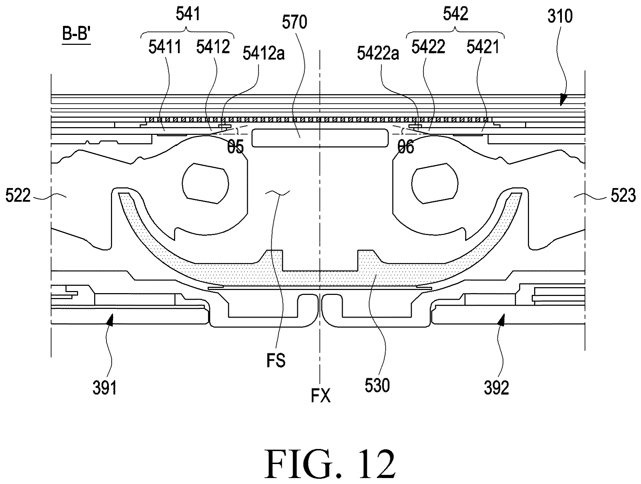

FIG. 10 is a cross-sectional view taken along reference line A-A' in a state in which components (e.g., the display 310, the hinge 320, the hinge cover 330, the plate 340, and the damping member 350) of FIG. 5 are assembled. Some or all of the components described with reference to FIG. 10 may be the same as those described with reference to FIGS. 1 to 9. Some or all of the components described with reference to FIG. 10 may be the same as those described with reference to FIGS. 11 and 12.

According to an embodiment, the electronic device 101 may include a first plate 441 and a second plate 442. The description of the first plate 441 and the second plate 442 may be identically applied to the description of the plates 341 and 342 described with reference to FIGS. 1 to 9.

According to an embodiment, the first plate 441 may include a first body portion 4411 and a first edge portion 4412. The first edge portion 4412 may extend from the first body portion 4411 toward the folding space FS. The first edge portion 4412 may be positioned between the first digitizer 3121 and the first hinge arm 322. The first edge portion 4412 may face the second edge portion 4422.

According to an embodiment, the second plate 442 may include a second body portion 4421 and a second edge portion 4422. The second edge portion 4422 may extend from the second body portion 4421 toward the folding space FS. The second edge portion 4422 may be positioned between the second digitizer 3122 and the second hinge arm 323. The second edge portion 4422 may face the first edge portion 4421.

According to an embodiment, the first edge portion 4412 may extend obliquely from the first body portion 4411. The first edge portion 4412 may be inclined toward the folding space FS. The first edge portion 4412 may be inclined with respect to a direction (e.g., +Z direction) parallel to the folding axis FX. The first edge portion 4412 may be inclined with respect to a direction (e.g., the +X direction) in which the first plate 441 and the second plate 442 are spaced apart from each other. The first edge portion 4412 may have an inclination angle θ3 with respect to a direction (e.g., the +X direction) in which the first plate 441 and the second plate 442 are spaced apart from each other. The first edge portion 4412 may be inclined away from the display 310 as it approaches the folding space FS. The first edge portion 4412 may include a first inclined surface 4412a at least partially facing the first digitizer 3121. The first edge portion 4412 may include a first inclined surface 4412a at least partially facing the display 310.

According to an embodiment, the second edge portion 4422 may extend obliquely from the second body portion 4421. The second edge portion 4422 may be inclined toward the folding space FS. The second edge portion 4422 may be inclined with respect to a direction (e.g., +Z direction) parallel to the folding axis FX. The second edge portion 4422 may be inclined with respect to a direction (e.g., the -X direction) in which the first plate 441 and the second plate 442 are spaced apart from each other. The first edge portion 4422 may have an inclination angle θ4 with respect to a direction (e.g., the +X direction) in which the first plate 441 and the second plate 442 are spaced apart from each other. The second edge portion 4422 may be inclined away from the display 310 as it approaches the folding space FS. The second edge portion 4422 may include a second inclined surface 4422a at least partially facing the second digitizer 3122. The second edge portion 4422 may include a second inclined surface 4422a at least partially facing the display 310.

According to an embodiment, the electronic device 101 may include damping members 451 and 452. The damping members 451 and 452 may include a first damping member 451 disposed between the first digitizer 3121 and the first plate 441 and a second damping member 452 disposed between the second digitizer 3122 and the second plate 442. The first damping member 451 may be spaced apart from the first inclined surface 4412a in a direction away from the folding space FS. The second damping member 452 may be spaced apart from the second inclined surface 4422a in a direction away from the folding space FS. The width w1 of the first damping member 451 may be smaller than the width of the first damping member 351 described with reference to FIG. 7A. The width w2 of the second damping member 452 may be smaller than the width of the second damping member 352 described with reference to FIG. 7A.

FIG. 11 is a view illustrating a structure in which a hinge 520, a plate 540, a support bar 570, and a connector 560 are assembled according to an embodiment of the disclosure. FIG. 12 is a cross-sectional view taken along reference line B-B' of FIG. 11. Some or all of the components described with reference to FIGS. 11 and 12 may be the same as those described with reference to FIGS. 1 to 10.

According to an embodiment, the electronic device 101 may include a hinge 520. The hinge 520 may be the same as the hinge 320 described with reference to FIGS. 1 to 10. For example, the hinge 520 may include a hinge body 521, a first hinge arm 522, and a second hinge arm 533.

According to an embodiment, the electronic device 101 may include a plate 540. The plate 540 may be the same as the plate 340 described with reference to FIGS. 1 to 10. For example, the plate 540 may include a first plate 541 and a second plate 542 spaced apart from each other.

According to an embodiment, the electronic device 101 may include a support bar 570. The support bar 570 may be disposed between the first plate 541 and the second plate 542. The electronic device 101 may include a connector 560. The connector 560 may connect the support bar 570 and the hinge cover 530.

According to an embodiment, the first plate 541 may be seated on the first hinge arm 522. The second plate 542 may be seated on the second hinge arm 523. The first plate 541 may include a first body portion 5411 and a first edge portion 5412 having a first inclined surface 5412a. The second plate 542 may include a second body portion 5421 and a second edge portion 5422 having a second inclined surface 5422a.

According to an embodiment, the first inclined surface 5412a may be inclined toward the support bar 570. According to an embodiment, the first inclined surface 5412a may be formed so that the width of the first edge portion 5412 gradually decreases toward the support bar 570. The first inclined surface 5412a may face the support bar 570. The first inclined surface 5412a may be inclined with respect to a direction in which the first plate 541 and the support bar 570 are spaced apart from each other. The first inclined surface 5412a may have an inclination angle θ5 with respect to a direction in which the first plate 541 and the support bar 570 are spaced apart from each other. According to an embodiment, the inclination angle may be formed at an upper portion or a lower portion of the first edge 5412.

According to an embodiment, the second inclined surface 5422a may be inclined toward the support bar 570. The second inclined surface 5422a may face the support bar 570. The second inclined surface 5422a may be inclined with respect to a direction in which the second plate 542 and the support bar 570 are spaced apart from each other. The second inclined surface 5422a may have an inclination angle θ6 with respect to a direction in which the second plate 542 and the support bar 570 are spaced apart from each other.

The electronic device may include a first housing and a second housing rotatably coupled to each other. The electronic device may include a flexible display disposed in the first housing and the second housing and at least partially deformable. When a load is applied to the flexible display, the flexible display may be bent into the inner space of the housing. When a structure supporting the flexible display is absent, the flexible display may be damaged by deformation of the flexible display.

An object of the disclosure may be to support the flexible display.

An object of the disclosure may be to manufacture the shape of the support structure according to the deformation direction of the flexible display.

Objects of the disclosure are not limited to the mentioned objects, and may be determined various without departing from the spirit and scope of the disclosure.

An electronic device according to various embodiments of the disclosure may support a flexible display by disposing a plate having an inclined end portion.

The electronic device according to various embodiments of the disclosure may support the flexible display by adjusting the direction of the inclined surface of the plate to the deformation direction of the flexible display.

Effects obtainable from the disclosure are not limited to the above-mentioned effects, and other effects not mentioned may be clearly understood by those skilled in the art from the following description.

An electronic device (e.g., 101 of FIGS. 1 to 12) according to an embodiment of the disclosure may include a first housing (e.g., 391 of FIGS. 1 to 12).

The electronic device (e.g., 101 of FIGS. 1 to 12) according to an embodiment of the disclosure may include a second housing (e.g., 392 of FIGS. 1 to 12) rotatably coupled to the first housing (e.g., 391 of FIGS. 1 to 12).

The electronic device (e.g., 101 of FIGS. 1 to 12) according to an embodiment of the disclosure may include a hinge (e.g., 320 of FIGS. 1 to 12) including a first hinge arm (e.g., 322 of FIGS. 1 to 12) connected to the first housing (e.g., 391 of FIGS. 1 to 12) and a second hinge arm (e.g., 323 of FIGS. 1 to 12) connected to the second housing (e.g., 392 of FIGS. 1 to 12).

The electronic device (e.g., 101 of FIGS. 1 to 12) according to an embodiment of the disclosure may include a flexible display (e.g., 310 of FIGS. 1 to 12) seated in the first housing (e.g., 391 of FIGS. 1 to 12) and the second housing (e.g., 392 of FIGS. 1 to 12).

The electronic device (e.g., 101 of FIGS. 1 to 12) according to an embodiment of the disclosure may include a flexible display (e.g., 310 of FIGS. 1 to 12) seated in the first housing (e.g., 391 of FIGS. 1 to 12) and the second housing (e.g., 392 of FIGS. 1 to 12) and spaced apart from each of the first hinge arm (e.g., 322 of FIGS. 1 to 12) and the second hinge arm (e.g., 322 of FIGS. 1 to 12).

The electronic device (e.g., 101 of FIGS. 1 to 12) according to an embodiment of the disclosure may include a first plate (e.g., 341 of FIGS. 1 to 12) disposed between the first hinge arm (e.g., 322 of FIGS. 1 to 12) and the flexible display (e.g., 310 of FIGS. 1 to 12).

The electronic device (e.g., 101 of FIGS. 1 to 12) according to an embodiment of the disclosure may include a second plate (e.g., 342 of FIGS. 1 to 12) disposed between the second hinge arm (e.g., 323 of FIGS. 1 to 12) and the flexible display (e.g., 310 of FIGS. 1 to 12) and spaced apart from the first plate (e.g., 341 of FIGS. 1 to 12).

A first plate (e.g., 341 of FIGS. 1 to 12) according to an embodiment of the disclosure may include a first edge portion (e.g., 3412 of FIGS. 1 to 12) having a first inclined surface (e.g., 3412a of FIGS. 1 to 12) inclined with respect to a direction in which the first plate (e.g., 341 of FIGS. 1 to 12) and the second plate (e.g., 342 of FIGS. 1 to 12) are spaced apart from each other.

A first plate (e.g., 341 of FIGS. 1 to 12) according to an embodiment of the disclosure may include a first edge portion (e.g., 3412 of FIGS. 1 to 12) having a first inclined surface (e.g., 3412a of FIGS. 1 to 12) inclined with respect to a direction in which the first hinge arm (e.g., 322 of FIGS. 1 to 12) and the flexible display (e.g., 310 of FIGS. 1 to 12) are spaced apart from each other.

The second plate (e.g., 342 of FIGS. 1 to 12) according to an embodiment of the disclosure may include a second edge portion (e.g., 3422 of FIGS. 1 to 12) having a second inclined surface (e.g., 3422a of FIGS. 1 to 12) inclined with respect to a direction in which the first plate (e.g., 341 of FIGS. 1 to 12) and the second plate (e.g., 342 of FIGS. 1 to 12) are spaced apart from each other.

The first edge portion (e.g., 3412 of FIGS. 1 to 12) and the second edge portion (e.g., 3422 of FIGS. 1 to 12) according to an embodiment of the disclosure may face each other in a direction in which the first plate (e.g., 341 of FIGS. 1 to 12) and the second plate (e.g., 342 of FIGS. 1 to 12) are spaced apart from each other.

The first inclined surface (e.g., 3412a of FIGS. 1 to 12) according to an embodiment of the disclosure may face the first hinge arm (e.g., 322 of FIGS. 1 to 12).

An inclination angle (e.g., θ1 of FIGS. 1 to 12) may be formed between the first inclined surface (e.g., 3412a of FIGS. 1 to 12) and the first hinge arm (e.g., 322 of FIGS. 1 to 12) according to an embodiment of the disclosure.

The electronic device (e.g., 101 of FIGS. 1 to 12) according to an embodiment of the disclosure may include a hinge cover (e.g., 330 of FIGS. 1 to 12) in which at least a portion of the hinge (e.g., 320 of FIGS. 1 to 12) is received.

At least a portion of the first inclined surface (e.g., 3412a of FIGS. 1 to 12) according to an embodiment of the disclosure may face the hinge cover (e.g., 330 of FIGS. 1 to 12).

The first hinge arm (e.g., 322 of FIGS. 1 to 12) according to an embodiment of the disclosure may include a first portion (e.g., 3221 of FIGS. 1 to 12) spaced apart from the first plate (e.g., 341 of FIGS. 1 to 12).

The first hinge arm (e.g., 322 of FIGS. 1 to 12) according to an embodiment of the disclosure may include a protrusion portion (e.g., 3222 of FIGS. 1 to 12) extending from the first portion (e.g., 3221 of FIGS. 1 to 12) toward the first plate (e.g., 341 of FIGS. 1 to 12).

The first hinge arm (e.g., 322 of FIGS. 1 to 12) according to an embodiment of the disclosure may include a second portion (e.g., 3223 of FIGS. 1 to 12) on which the first plate (e.g., 341 of FIGS. 1 to 12) is seated and which faces the first inclined surface (e.g., 3412a of FIGS. 1 to 12).

A folding space (e.g., the FS of FIGS. 1 to 12) in which the flexible display is deformed may be formed between the first plate (e.g., 341 of FIGS. 1 to 12) and the second plate (e.g., 342 of FIGS. 1 to 12) according to an embodiment of the disclosure.

The first inclined surface (e.g., 3412a of FIGS. 1 to 12) according to an embodiment of the disclosure may be inclined toward the folding space (e.g., FS of FIGS. 1 to 12).

The first inclined surface (e.g., 3412a of FIGS. 1 to 12) according to an embodiment of the disclosure may be inclined to approach the flexible display (e.g., 310 of FIGS. 1 to 12) toward the second plate (e.g., 342 of FIGS. 1 to 12).

The electronic device (e.g., 101 of FIGS. 1 to 12) according to an embodiment of the disclosure may include a damping member (e.g., 350 of FIGS. 1 to 12) disposed between the flexible display (e.g., 310 of FIGS. 1 to 12) and the first plate (e.g., 341 of FIGS. 1 to 12).

The flexible display (e.g., 310 of FIGS. 1 to 12) according to an embodiment of the disclosure may include a panel (e.g., 311 of FIGS. 1 to 12).

The flexible display (e.g., 310 of FIGS. 1 to 12) according to an embodiment of the disclosure may include a first digitizer (e.g., 3121 of FIGS. 1 to 12) disposed between the panel (e.g., 311 of FIGS. 1 to 12) and the first plate (e.g., 341 of FIGS. 1 to 12) and facing the first edge portion (e.g., 3412 of FIGS. 1 to 12).

The first inclined surface (e.g., 4412a of FIGS. 1 to 12) according to an embodiment of the disclosure may face the flexible display (e.g., 310 of FIGS. 1 to 12).

A folding space (e.g., FS of FIGS. 1 to 12) in which the flexible display (e.g., 310 of FIGS. 1 to 12) is deformed may be formed between the first plate (e.g., 441 of FIGS. 1 to 12) and the second plate (e.g., 442 of FIGS. 1 to 12) according to an embodiment of the disclosure.

The first inclined surface (e.g., 4412a of FIGS. 1 to 12) according to an embodiment of the disclosure may be inclined to approach the first hinge arm (e.g., 322 of FIGS. 1 to 12) toward the folding space (e.g., FS of FIGS. 1 to 12).

The electronic device (e.g., 101 of FIGS. 1 to 12) according to an embodiment of the disclosure may include a support bar (e.g., 570 of FIGS. 1 to 12) disposed between the first plate (e.g., 541 of FIGS. 1 to 12) and the second plate (e.g., 542 of FIGS. 1 to 12) and facing the first inclined surface (e.g., 5412a of FIGS. 1 to 12).

The first inclined surface (e.g., 5412a of FIGS. 1 to 12) according to an embodiment of the disclosure may be inclined away from the first hinge arm (e.g., 522 of FIGS. 1 to 12) toward the support bar (e.g., 570 of FIGS. 1 to 12).

The electronic device (e.g., 101 of FIGS. 1 to 12) according to an embodiment of the disclosure may include a flexible display (e.g., 310 of FIGS. 1 to 12) seated in the first housing (e.g., 391 of FIGS. 1 to 12) and the second housing (e.g., 392 of FIGS. 1 to 12) and at least partially deformably formed.

The electronic device (e.g., 101 of FIGS. 1 to 12) according to an embodiment of the disclosure may include a hinge (e.g., 320 of FIGS. 1 to 12) rotatably connecting the first housing (e.g., 391 of FIGS. 1 to 12) and the second housing (e.g., 392 of FIGS. 1 to 12).

The electronic device (e.g., 101 of FIGS. 1 to 12) according to an embodiment of the disclosure may include a first plate (e.g., 341 of FIGS. 1 to 12) disposed between the flexible display (e.g., 310 of FIGS. 1 to 12) and the hinge (e.g., 320 of FIGS. 1 to 12).

The electronic device (e.g., 101 of FIGS. 1 to 12) according to an embodiment of the disclosure may include a second plate (e.g., 342 of FIGS. 1 to 12) disposed between the flexible display (e.g., 310 of FIGS. 1 to 12) and the hinge (e.g., 320 of FIGS. 1 to 12) and spaced apart from the first plate (e.g., 341 of FIGS. 1 to 12).

A folding space (e.g., FS of FIGS. 1 to 12) in which the flexible display (e.g., 310 of FIGS. 1 to 12) is deformed may be formed between the first plate (e.g., 341 of FIGS. 1 to 12) and the second plate (e.g., 342 of FIGS. 1 to 12) according to an embodiment of the disclosure.

The first plate (e.g., 341 of FIGS. 1 to 12) and the second plate (e.g., 342 of FIGS. 1 to 12) according to an embodiment of the disclosure may include edge portions (e.g., 3412 and 3422 of FIGS. 1 to 12) inclined toward the folding space (e.g., FS of FIGS. 1 to 12).

The first plate (e.g., 341 of FIGS. 1 to 12) according to an embodiment of the disclosure may include a first inclined surface (e.g., 3412a of FIGS. 1 to 12) inclined with respect to a direction in which the first plate (e.g., 341 of FIGS. 1 to 12) and the second plate (e.g., 342 of FIGS. 1 to 12) are spaced apart from each other.

The second plate (e.g., 342 of FIGS. 1 to 12) according to an embodiment of the disclosure may include a second inclined surface (e.g., 3422a of FIGS. 1 to 12) inclined with respect to a direction in which the first plate (e.g., 341 of FIGS. 1 to 12) and the second plate (e.g., 342 of FIGS. 1 to 12) are spaced apart from each other.

The edge portion (e.g., 3412 or 3422 of FIGS. 1 to 12) according to an embodiment of the disclosure may include inclined surfaces (e.g., 3412a or 3422a of FIGS. 1 to 12) facing the hinge (e.g., 320 of FIGS. 1 to 12).

The edge portions (e.g., 3412 and 3422 of FIGS. 1 to 12) according to an embodiment of the disclosure may be configured to be deformable toward the hinge (e.g., 320 of FIGS. 1 to 12).

The edge portions (e.g., 4412 and 4422 of FIGS. 1 to 12) according to an embodiment of the disclosure may include inclined surfaces (e.g., 4412a and 4422a of FIGS. 1 to 12) approaching the flexible display (e.g., 310 of FIGS. 1 to 12) toward the folding space (e.g., FS of FIGS. 1 to 12).

While the disclosure has been shown and described with reference to exemplary embodiments thereof, it will be apparent to those of ordinary skill in the art that various changes in form and detail may be made thereto without departing from the spirit and scope of the disclosure as defined by the following claims.

## Claims

1. An electronic device (101) comprising:
a first housing (391);
a second housing (392) rotatably disposed with respect to the first housing (391);
a hinge (320) including a first hinge arm (322) connected to the first housing (391) and a second hinge arm (323) connected to the second housing (392);
a flexible display (310) disposed on the first housing (391) and the second housing (392) and spaced apart from each of the first hinge arm (322) and the second hinge arm (323);
a first plate (341) disposed between the first hinge arm (322) and the flexible display (310); and
a second plate (342) disposed between the second hinge arm (323) and the flexible display (310) and spaced apart from the first plate (341),
wherein the first plate (341) comprises a first edge portion (3412) including a first inclined surface (3412a) inclined with respect to a direction in which the first hinge arm (322) and the flexible display (310) are spaced apart from each other.

2. The electronic device of claim 1,
wherein the second plate (342) comprises:
a second edge portion (3422) including a second inclined surface (3422a) inclined with respect to a direction in which the first plate (341) and the second plate (342) are spaced apart from each other.

3. The electronic device of claim 2,
wherein the first edge portion (3412) and the second edge portion (3422) face each other in the direction in which the first plate (341) and the second plate (342) are spaced apart from each other.

4. The electronic device of any one of claims 1 to 3,
wherein at least a portion of the first incline surface (3412a) faces the first hinge arm (322).

5. The electronic device of any one of claims 1 to 4,
wherein an inclination angle (01) is formed between the first inclined surface (3412a) and the first hinge arm (322).

6. The electronic device of any one of claims 1 to 5, further comprising:
a hinge cover (330) in which at least a portion of the hinge (320) is configured to be received, and
wherein at least a portion of the first inclined surface (3412a) faces the hinge cover (330).

7. The electronic device of any one of claims 1 to 6,
wherein the hinge arm (322) comprises:
a first portion (3221) spaced apart from the first plate (341);
a protrusion portion (3222) extending toward the first plate (341) from the first portion (3221); and
a second portion (3223) on which the first plate (341) is seated and facing the first inclined surface (3412a).

8. The electronic device of any one of claims 1 to 7, further comprising:
a folding space (FS) to which the flexible display (310) is deformable and formed between the first plate (341) and the second plate (342), and
wherein the first inclined surface (3412a) is inclined toward the folding space (FS).

9. The electronic device of any one of claims 1 to 8,
wherein the first inclined surface (3412a) is configured to come closer to the flexible display (310) from a first edge of the first inclined surface (3412a) to a second edge of the first inclined surface (3412a) which is opposite to the first edge.

10. The electronic device of any one of claims 1 to 9, further comprising:
a damping member (350) including a flexible material and disposed between the flexible display (310) and the first plate (341).

11. The electronic device of any one of claims 1 to 10,
wherein the flexible display (310) comprises:
a panel (311); and
a first digitizer (3121) disposed between the panel (311) and the first plate (341) and facing the first edge portion (3412).

12. The electronic device of any one of claims 1 to 11,
wherein the first inclined surface (4412a) faces an opposite direction to a direction in which the first hinge arm (322) is disposed with respect to the first plate (441).

13. The electronic device of any one of claims 1 to 12, further comprising:
a folding space (FS) to which the flexible display (310) is deformable and formed between the first plate (341) and the second plate (342), and
wherein the first inclined surface (4412a) is configured to come closer to the first hinge arm (322) as the first inclined surface approaches to the folding space (FS).

14. The electronic device of any one of claims 1 to 13, further comprising:
a support bar (570) disposed between the first plate (541) and the second plate (542) and facing the first inclined surface (5412a).

15. The electronic device of claim 14,
wherein the first inclined surface (5412a) is configured to come farther from the first hinge arm (522) from a first edge to a second edge which is opposite to the first edge.
